Europäisches Patentamt

European Patent Office

Office européen des brevets

(19)

(11) Veröffentlichungsnummer: **0 173 849 B1**

(12) # EUROPÄISCHE PATENTSCHRIFT

(45) Veröffentlichungstag der Patentschrift: **05.06.91**

(51) Int. Cl.⁵: **H01L 21/00**, G03F 7 207, G02B 7/28

(21) Anmeldenummer: **85109357.5**

(22) Anmeldetag: **25.07.85**

(54) Laserstrahl-Lithograph.

(30) Priorität: **26.07.84 DE 3427611**

(43) Veröffentlichungstag der Anmeldung:
**12.03.86 Patentblatt 86/11**

(45) Bekanntmachung des Hinweises auf die
Patenterteilung:
**05.06.91 Patentblatt 91/23**

(84) Benannte Vertragsstaaten:
**AT CH DE FR GB IT LI NL**

(56) Entgegenhaltungen:
**EP-A- 0 054 315**
**EP-A- 0 082 479**
**DE-A- 2 012 394**

(73) Patentinhaber: **Heidelberg Instruments GmbH**
**Im Neuenheimer Feld 518**
**W-6900 Heidelberg 18(DE)**

(72) Erfinder: **Bille, Josef, Prof. Dr.**
**Am Pferchelhang 2/4**
**W-6900 Heidelberg(DE)**
Erfinder: **Hunklinger, Siegfried, Prof. Dr.**
**Am Büchsenackerhang 68**
**W-6900 Heidelberg(DE)**

(74) Vertreter: **Lutz, Johannes Dieter, Dr.rer.nat.**
**Eugensplatz 5**
**W-7000 Stuttgart 1(DE)**

Rank Xerox (UK) Business Services

## Beschreibung

Die Erfindung betrifft einen Laserstrahl-Lithographen für die Herstellung hochintegrierter Halbleiter-Bauelemente und mit den weiteren, im Oberbegriff des Patentanspruchs 1 genannten, gattungsbestimmenden Merkmalen.

Ein Laserstrahl-Lithograph dieser Art ist von der Firma TRE Semiconductor Equipment Corporation, Californien,USA entwickelt und vorgestellt worden, vgl. EP-A-0082479.

Bei dem bekannten Laserstrahl-Lithographen wird das zum Aufzeichnen bzw. "Schreiben" der gewünschten Struktur auf eine Fotolackschicht ausgenutzte Laser-Licht durch Mehrfach-Aufspaltung eines Primärstrahles gewonnen, um durch eine erhöhte Anzahl von Belichtungs-Strahlen eine möglichst hohe Arbeitsfrequenz zu erzielen. Bei diesem bekannten Laserstrahl-Lithographen kann die Fokussierung sämtlicher Belichtungsstrahlen nur in einer einzigen Ebene erfolgen kann. Der Einsatz des bekannten Laserstrahl-Lithographen ist daher, abgesehen von der Herstellung von Masken allenfalls noch dann möglich, wenn in einem sogenannten Zwei-Stufen-Fotolack-Prozeß gearbeitet wird, wobei eine "dicke" Fotolackschicht Unebenheiten der Wafer ausgleicht und auf diese Ausgleichs-Fotolackschicht eine dünne weitere Fotolackschicht aufgebracht wird, die letztlich für das Aufzeichnen der vorgesehenen Struktur ausgenutzt wird. Weiter müssen bei dem bekannten Laserstrahl-Lithographen die einzelnen Lichtbündel in geometrisch exakt gleich langen optischen Wegen geführt sein, um die Fokussierung in einer einzigen Ebene zu gewährleisten, die erforderlich ist, weil die Auslenkung der Lichtbündel mit nur einem einzigen Reflektor erfolgen kann.

Der zur Realisierung des bekannten Laserstrahl-Lithographen erforderliche technische Aufwand ist erheblich. Die für die funktionsgerechte Justierung erforderlichen Arbeiten sind äußerst aufwendig und nur von spezialisierten Fachleuten durchführbar. Der Einsatz des bekannten Lithographen ist daher schon insoweit, bislang jedenfalls auf einen Laboreinsatz beschränkt gewesen. Seine industrielle Einsetzbarkeit erscheint fraglich. Es kommt hinzu, daß der Lithograph hinsichtlich der Schreibgeschwindigkeit beschränkt ist, da er allenfalls eine Ansteuerung mit einer Frequenz von 10 MHz zuläßt.

Zwar sind zur Herstellung von Halbleiter-Bauelementen auch Elektronenstrahl-Lithographen bekannt, die eine höhere Arbeitsfrequenz von bis zu 20 MHz zulassen. Derartige Lithographen sind jedoch teuer und erfordern aufwendige Vakuum-Anlagen, die störanfällig sind.

Aufgabe der Erfindung ist es daher, einen Laserstrahl-Lithographen der eingangs genannten Art zu schaffen, der eine höhere Arbeitsfrequenz erlaubt, in einem kompakten und einfachen Aufbau realisierbar ist und im übrigen auch eine direkte Belichtung der Wafer-Oberfläche zuläßt.

Diese Aufgabe wird erfindungsgemäß durch die im kennzeichnenden Teil des Patentanspruchs 1 genannten Merkmale gelöst.

Der erfindungsgemäße Laserstrahl-Lithograph erlaubt eine Ansteuerung mit 40 MHz - Signalen und damit eine Reduzierung der Insgesamt-Belichtungszeit auf die Hälfte, verglichen mit einem Elektronenstrahl-Lithographen und auf ein Viertel, verglichen mit dem bekannten Lasterstrahl-Lithographen. Der erfindungsgemäße Laserstrahl-Lithograph erfordert keinerlei Aufwand hinsichtlich der Justierung und ermöglicht - während des Herstellungsvorganges - eine selbsttätige Nachfokussierung im Sinne optimal geringer Brennfleck-Durchmesser. Die Strukturgenauigkeit der durch Belichtung von Fotolackschichten zu erzeugenden Strukturen wird dadurch erheblich verbessert.

In der durch die Merkmale des Anspruchs 2 umrissenen und durch diejenigen der Ansprüche 3 und 4 näher spezifizierten Gestaltung ist der erfindungsgemäße Lasterstrahl-Lithograph als Mehrkanal-System ausgebildet, das eine um einen der Anzahl der Belichtungskanäle entsprechenden Faktor erhöhte Arbeitsgeschwindigkeit zuläßt.

Durch die Merkmale des Anspruchs 5 wird erreicht, daß nacheinander zu belichtende streifenförmige Bereiche einer Wafer hinsichtlich ihrer strukturellen Einzelheiten sehr exakt aneinander angeschlossen werden können.

Weitere Einzelheiten und Merkmale der Erfindung ergeben sich aus der nachfolgenden Beschreibung spezieller Ausführungsbeispiele anhand der Zeichnung. Es zeigen:

Fig.1     ein Blockschaltbild eines erfindungsgemäßen Laserstrahl-Lithographen, der als Ein-Kanal-System ausgebildet ist,

Fig.2     ein Schaubild zur Erläuterung der Belichtungs-Steuerung,

Fig.3     ein Block-Diagramm zur Erläuterung eines Verfahrens zur selbsttätigen Nachfokussierung des Belichtungsstrahls auf die Wafer-Oberfläche,

Fig.4     eine vereinfachte Teildarstellung eines elektrisch ansteuerbaren aktiven Spiegels und

Fig.5     eine Strahl-Formungsoptik eines als Mehrkanal-Systems ausgebildeten erfindungsgemäßen Laser-Lithographen.

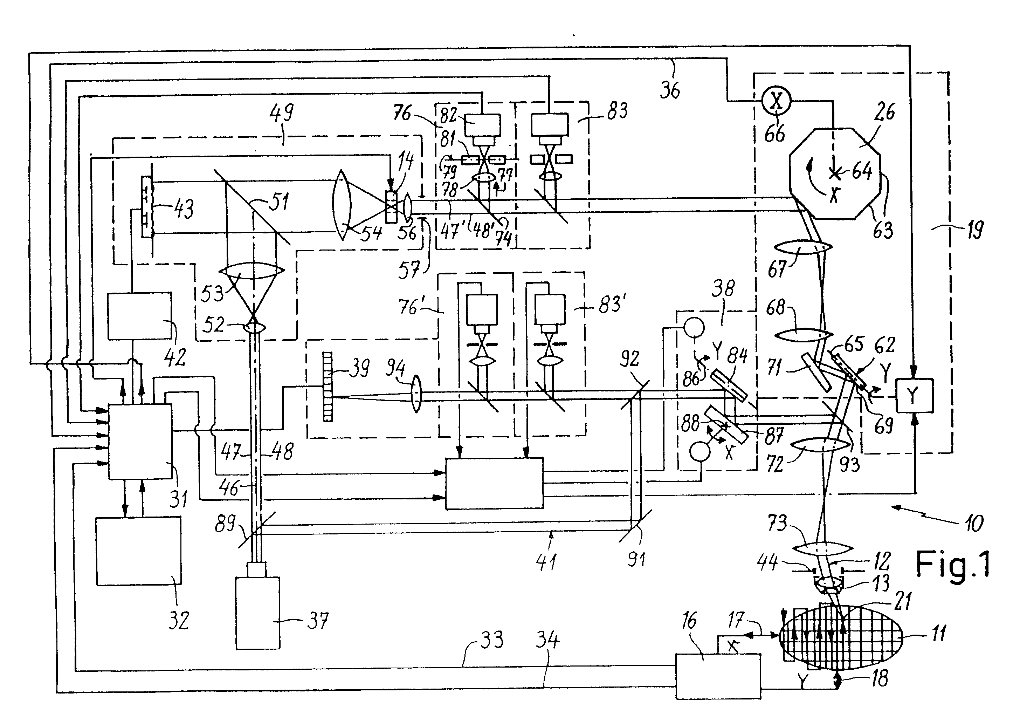

Der in der Fig.1, auf deren Einzelheiten ausdrücklich verwiesen sei, dargestellte, erfindungsgemäße Laserstrahl-Lithograph 10 dient im Rahmen der Herstellung von hochintegrierten Halbleiter-Bauelementen, die z.B. in einem Planarprozeß mit einer Vielzahl von einzelnen Prozeßschritten hergestellt werden, zur strukturgerechten Belichtung von Fotolackschichten, die zur Vorbereitung z.B. von Aufdampf-, Diffusions-, Implantations- und Oxidationsprozessen, denen feinststrukturierte Oberflächenbereiche einer Wafer 11 ausgesetzt werden sollen, auf diese aufgebracht werden; nach einem Belichtungsvorgang - "Schreiben" der vorgesehenen Struktur - werden dann in einem Entwicklungsvorgang, je nach Typ des verwendeten Fotolacks, entweder dessen belichtete oder dessen nicht belichtete Teile von der sie tragenden Schicht entfernt und die auf der Unterlage verbleibenden Teile der Fotolackschicht als Maske im Rahmen des jeweils folgenden Verfahrensschrittes ausgenutzt. In zweckentsprechender Ausnutzung einer Fotolackschicht kann diese auch als Träger für eine weitere Schicht, z.B. eine leitende Metallschicht benutzt werden, wobei dann, wiederum je nach Typ des Fotolacks zusammen mit den belichteten oder den nicht belichteten Teilen der Fotolackschicht die auf diese aufgebrachten Bereiche der weiteren Schicht, z.B. in einem Ätzvorgang, mitentfernt werden.

Der erfindungsgemäße Laserstrahl-Lithograph 10 soll ein möglichst rasches, strukturgetreues Belichten der für die jeweiligen Produktionsphasen erforderlichen Fotolackschichten ermöglichen.

Anhand der nachfolgend beschriebenen konstruktiven und funktionellen Details des Laserstrahl-Lithographen 10 werden auch Verfahrensweisen zu dessen zweckgerechter Benutzung erläutert werden, die ebenfalls als zum Gegenstand der Erfindung gehörig angesehen werden sollen.

Bei der durch die Fig.1 wiedergegebenen Ausführungsform des Laserstrahl-Lithographen 10 ist dieser als ein Ein-Kanal-System ausgebildet, bei dem nur ein einziges, insgesamt mit 12 bezeichnetes Laserlichtbündel zur Belichtung der einer Fotolackschicht aufzuprägenden Struktur benutzt wird. Dieses Laser-Lichtbündel 12 wird mittels eines Mikroskopobjektivs 13 auf die Oberfläche der zu belichteten Fotolackschicht der Wafer 11 fokussiert, wobei der Brennfleck, entsprechend der Halbwertsbreite des Gauß'schen Intensitätsprofils des Laser-Lichtbündels im Fokus, einen typischen Durchmesser von etwa 0,25 $\mu$m hat.

Die Intensität des Laser-Lichtbündels 12 kann mittels eines akusto-optischen Modulators 14 im Verhältnis 500/1 verändert werden. Sie kann erforderlichenfalls fein abgestuft werden.

Mittels einer lediglich schematisch angedeuteten Wafer-Transporteinrichtung 16 kann die Wafer 11 in den durch die Pfeile 17 und 18 markierten X- und Y-Koordinatenrichtungen hin- und herverfahren werden, wobei die mittels der Wafer-Transporteinrichtung ausführbaren X- und Y-Transporthübe hinreichend groß sind, um die gesamte Wafer-Oberfläche dem Laser-Lichtbündel 12 aussetzen zu können.

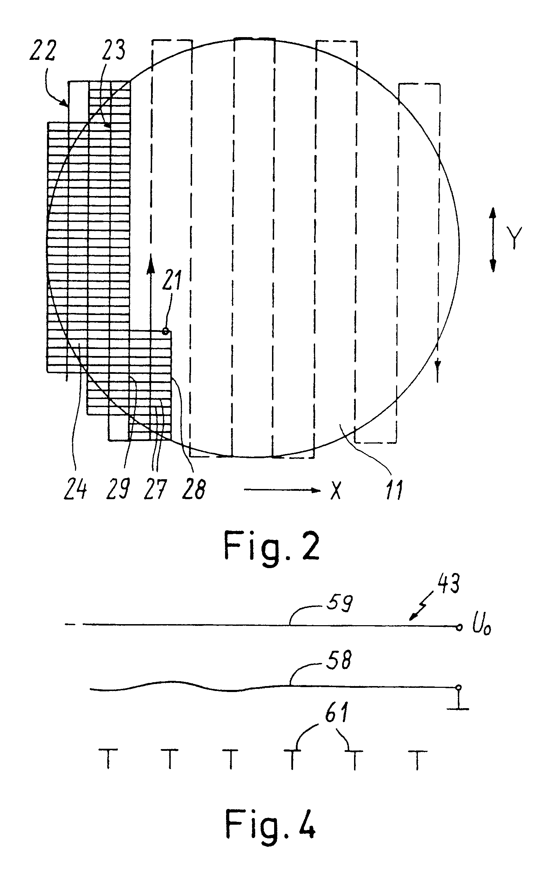

nen. Mittels einer insgesamt mit 19 bezeichneten, ersten optischen Abtasteinrichtung ist innerhalb des Gesichtsfeldes des Mikroskopobjektivs 13, die einen typischen Wert von 250 m hat eine in X-Richtung erfolgende Zeilen-Ablenkung des Laser-Lichtbündels 12 bzw. des Brennflecks 21 (Fig.2) möglich. Im Verlauf eines Belichtungsvorganges wird die Wafer 11 mittels der Transporteinrichtung 16 entlang an mäander- bzw. rechteckwellenförmigen Bahn, die teilweise in ausgezogenen, teilweise in gestrichelten Linien dargestellt ist, unter dem Mikroskopobjektiv vorbeigeführt, wobei typische Werte der Vorschubgeschwindigkeit in Y-Richtung zwischen 1mm·s und 5mm·s betragen. Durch die gleichzeitig wirksame Zeilenablenkung des Laser-Lichtbündels 12 bzw. des Brennflecks 21, die mit wesentlich größerer Geschwindigkeit in X-Richtung, z.B. mit einer Geschwindigkeit von 5 m·s erfolgt, wird somit von dem Laser-Lichtbündel, während sich die Wafer 11 entlang eines sich in Y-Richtung erstreckenden Abschnittes 23 der Mäanderbahn 22 bewegt, ein streifenförmiger Bereich 24 überstrichen, der, eine zweckmäßige Abstimmung der Zeilen-Ablenkgeschwindigkeit und der Vorschubgeschwindigkeit in Y-Richtung vorausgesetzt, an jeder Stelle belichtet werden kann. Die Zeilenauslenkung wird mittels eines in der aus der Fig. 1 ersichtlichen Anordnung vorgesehenen, rotierend antreibbaren Polygonspiegel 26 erzielt, mit der Folge, daß sich der Brennfleck 21 in parallelen Zeilen 27 jeweils von dem einen Rand 28 zum gegenüberliegenden Rand 29 eines jeden streifenförmigen Bereiches 24 bewegt. In spezieller Auslegung der Wafer-Transporteinrichtung ist die Vorschub-Geschwindigkeit in Y-Richtung so einstellbar, daß der in Y-Richtung gemessene Abstand zweier nacheinander überstrichener Abtast-Zeilen 27 etwa gleich dem halben Brennfleck-Durchmesser ist, beim gewählten Erläuterungsbeispiel somit 0,125 $\mu$m beträgt.

Der zur Helligkeits- bzw. Hell-dunkel-Steuerung des Laser-Lichtbündels 12 vorgesehene akusto-optische Modulator 14 ist mit einem 40 MHz-Signal ansteuerbar, d.h. die Intensität des Laser-Lichtbündels ist in 1 Sekunde auf 40 Millionen verschiedene Werte einstellbar. Wenn vorgesehen wird, daß pro Zeile 27 2000 Bildpunkte belichtbar sein sollen, was einem Abstand derselben in X-Richtung von 0,125 $\mu$m entspricht, so können pro Sekunde 20 000 Zeilen 27 punktweise belichtet werden, deren Zeilenabstand ebenfalls 0,125 $\mu$m beträgt, und es ergibt sich für die Belichtung ein in X-und Y-Richtung äquidistantes Punkt- und Zeilenraster.

Die durch Belichtung der jeweiligen Fotolackschicht zu erzeugende Struktur ist in einem mit einem Rechner 31 kombinierten Plattenspeicher gespeichert und kann mit Fortschreiten des Belichtungsvorganges sukzessive in den Rechner eingelesen und von diesem zur zweckgerechten Ansteuerung des akusto-optischen Modulators 14 verarbeitet werden. Der Rechner 31 ist dabei durch von der Wafer-Transporteinrichtung 16 empfangene Rückmeldesignale, die die Information über die Momentanstellung der Wafer 11 enthalten sowie durch Rückmeldesignale, die die Information über den Momentanbetrag der Zeilenauslenkung enthalten und dem Rechner über die Signalleitungen 33 und 34 sowie die Zeilenauslenkungs- und Rückmeldeleitung 36 zugeleitet werden, mit der Wafer-Bewegung bzw. der Zeilen-Abtastbewegung des Laser-Lichtündels 12 synchronisiert.

Zur Belichtung der jeweiligen Fotolackschicht wird die UV-Emission eines Argon-Lasers 37 ausgenutzt, der UV-Licht der Wellenlänge $\lambda_1$ = 270nm emittiert, bei der die üblicherweise benutzten Fotolacke hinreichend empfindlich sind. Der Argon-Laser emittiert außerdem Licht der Wellenlänge $\lambda_2$ = 514 nm, das mit Hilfe einer zweiten, insgesamt mit 38 bezeichneten Abtasteinrichtung, die ihrerseits in der Art eines Laser-Abtastmikroskops arbeitet, zur Erfassung der sogenannten Punktbildfunktion, d.h. der räumlichen Intensitätsverteilung an ausgewählten Punkten oder Bereichen der Wafer-Oberfläche reflektierten Lichtes ausgenutzt wird. Diese zweite Abtasteinrichtung 38 wird asynchron zu der ersten Abtasteinrichtung 19 und mit wesentlich geringerer Abtastfrequenz betrieben. Das von der Waferoberfläche durch Reflexion in den Strahlengang der zweiten Abtasteinrichtung 38 zurückgeworfene Licht wird mit einer zweidimensionalen (2d) Matrixanordnung fotoelektrischer Empfänger, vorzugsweise einer Diodenmatrix 39 hinsichtlich seiner zweidimensional-räumlichen Intensitätsverteilung erfaßt, wobei die Intensitätsverteilung der jeweils von einem beleuchteten Oberflächenelement der Wafer 11 zurückgeworfenen Strahlung gemessen und für eine weitere Verarbeitung gespeichert wird. Aus der solchermaßen erfaßten Punktbildfunktion wird unter Anwendung bekannter Algorithmen, deren Grundzüge im folgenden zum besseren Verständnis noch kurz erläutert werden von dem Rechner 31 ein Vergleich der gemessenen Intensitätsverteilung mit einer für genaue Fokussierung des insgesamt mit 41 bezeichneten Abtast-Lichtbündels auf die abgetastete Wafer-Oberfläche charakteristischen - idealen - Punktbild-Funktion durchgeführt. Weicht die gemessene Punktbild-Funktion von der idealen ab, so wird ein dem Rechner 31 nachgeschalteter Steuersignalgeber 42 aktiviert, mit dessen Ausgangssignalen ein sogenannter aktiver Spiegel 43, d.h. ein Spiegel mit elektrisch steuerbarer Brechkraft angesteuert wird, der nunmehr im Belichtungs-Strahlengang des Laser-Lithographen 10 eine kompensatorische Fokusversetzung dahingehend vermittelt, daß das Belichtungs-Laserlichtbündel 12 innerhalb enger Toleranzen exakt auf die Oberfläche der zu blichtenden Fotolackschicht fokussiert wird. Auf diese Weise kann im Verlauf der Belichtung einer Fotolackschicht eine fortlaufende, selbsttätige Nachjustierung des Brennflecks 21 des Belichtungs-Laserlichtbündels auf die Oberfläche der jeweiligen Fotolackschicht erzielt werden. Es versteht sich, daß diese Nachfokussierung nicht für jeden zu belichtenden Punkt durchgeführt werden kann, sondern, weil die rechnerische Verarbeitung der Punktbild-Funktion eine gewisse Zeit benötigt, beispielsweise nur für jede der zu belichtenden Zeilen 27.

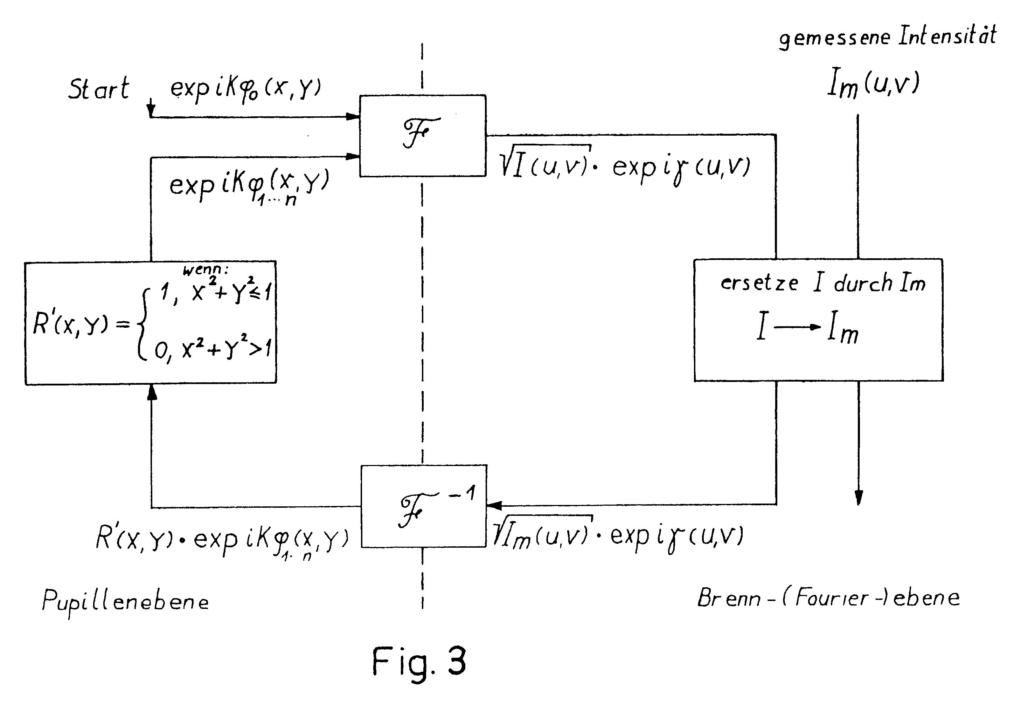

Zu einer vereinfachten Erläuterung des Rechenverfahrens, nach welchem der Rechner 31 die mittels der zweiten Abtasteinrichtung 38 gewonnenen Punktbild-Funktionsdaten verarbeitet, sei nunmehr auf die Fig.3 verwiesen, in der dieses Rechenverfahren schematisch dargestellt ist: dieses Verfahren besteht in der Durchführung einer Iteration, wonach unter Berücksichtigung der mit derDiodenmatrix 39 erfaßten Intensitätsverteilung (der Punktbild-Funktion) $I_m(uv)$ (u = Zeilenindex, s = Spaltenindex der Diodenmatrix) ein Verlauf der Wellenfront des Abtastlichtes am Ort der Eintrittspupille 44 des Mikroskopobjektivs 13 errechnet wird, der mit der gemessenen Intensitätsverteilung $I_m(uv)$ konsistent ist.

Ausgegangen wird dabei von der plausiblen Annahme, daß das Lichtfeld am Ort (x,y) der Eintrittspupille 44 des Mikroskopobjektivs 13 eine durch einen Phasenfaktor $\phi_0(x,y)$ charakterisierbare ebene Wellenfront habe. Unter Berücksichtigung der Übertragungsfunktion des optischen Systems insgesamt durch Faltung der Wellenfront R(x,y) exp-ik$\phi_0$(x,y) mit der Übertragungsfunktion F dieses Systems wird der Verlauf des Lichtfeldes $\sqrt{I(u,v)}$. expi γ(u,v) in der Brennebene - der Oberfläche der zu belichtenden Fotolackschichtdes Mikroskopobjektivs 13 berechnet. Durch Ersatz der Amplitudenfaktoren $\sqrt{I(u,v)}$, durch die aus der Messung gewinnbaren Werte

$$\sqrt{I_m(u,v)}$$

und Anwendung der inversen Übertragungsfunktion $F^{-1}$ auf diesen für die Brennebene bzw. die Wafer-Oberfläche angesetzten Lichtfeldverlauf wird nunmehr ein mit diesem Feldverlauf konsistenter Verlauf der Wellenfront an der Eintrittspupille 44 des Mikroskopobjektivs 17, d.h. ein damit konsistenter Phasenfaktor $\phi_1(x,y)$ errechnet. Im ersten Iterationsschritt wird nun dieser Phasenfaktor für die Beschreibung des Lichtfeldes am Ort der Eintrittspupille angesetzt und wieder, wie zuvor beschrieben, das Wellenfeld in der Brennebene des Mikroskopobjektivs 17 errechnet; des weiteren werden die Amplitudenfaktoren durch die Wurzeln der gemessenen Intensitätswerte ersetzt und der neue Phasenfaktor $\phi_2(x,y)$ berechnet. Derartige Iterationsschritte werden solange wiederholt, bis die gemessenen Intensitäten $I_m(u,v)$ innerhalb vorgebbarer Schranken mit den errechneten Intensitätswerten übereinstimmen und auf diese Weise eine Wellenfront am Ort der Eintrittspupille 44 des Mikroskopobjektivs bestimmt ist, mit der die gemessenen Intensitätswerte konsistent sind. Aus dem Vergleich der sich aus dem Iterationsverfahren ergebenden Wellenfront mit der für den Idealfall angenommenen Feldverteilung an der Eintrittspupille 44 des Mikroskopobjektivs 17 können die mithilfe des Rechners 31 und des Steuersignalgebers 42 erzeugbaren Steuersignale zum vorstehend erläuterten Zweck gewonnen werden.

Der insoweit anhand seines grundsätzlichen Aufbaus und seiner wesentlichen Funktionen erläuterte Laserstrahl-Lithograph 10 ist weiter durch die folgenden baulichen und funktionellen Einzelheiten charakterisiert:

der in der Fig.1 durch seinen strich-punktiert eingezeichneten Zentralstrahl 46 und seine Randstrahlen 47 und 48 repräsentierte Primärstrahl des Argonlasers 37 ist im wesentlichen ein Parallelbündel mit einem Bündelquerschnitt von ca. 1mm². Er wird mittels einer insgesamt mit 49 bezeicheten Strahlformungs- und Fokus-Einstellungsoptik, die den aktiven Spiegel 43 umfaßt, auf die für die weitere Ausnutzung des Laserlichts geeignete Bündelform gebracht im Sinne einer Anpassung des Bündelquerschnittes an die zur weiteren optischen Verarbeitung vorhandenen optischen Einrichtungen sowie im Sinne einer gezielten Nachfokussierung, gegebenenfalls auch einer gezielten Defokussierung des Laserlichtbündels 12 im Bereich der zu belichtenden Fotolackschicht. Eine gezielte Defokussierung des Laser-Lichtbündels 12 zur Vergrößerung des Brennflecks 21, die mittels des Rechners 31 steuerbar ist, kann zweckmäßig sein, wenn relativ breite und großflächige Bereiche gleichmäßig belichtet werden sollen.

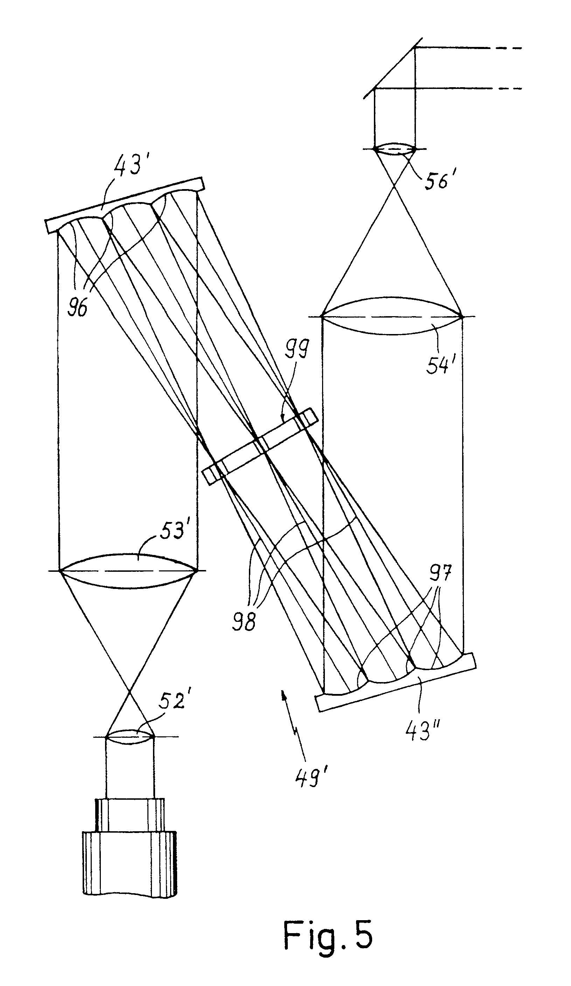

Der aktive Spiegel ist in einer zur Ebene der Eintrittspupille 44 des Mikroskopobjektivs entsprechenden Pupillenebene 44' angeordnet. Er wird - beim dargestllten Ausführungsbeispiel - über einen teildurchlässigen, z.B. halbdurchlässigen, Spiegel 51 ausgeleuchtet, der den mittels einer telezentrischen Linsenanordnung, die die beiden Sammellinsen 52 und 53 verschiedener Brennweiten umfaßt, aufgeweiteten Primärlichtstrahl 46, 47,48 des Argonlasers 37 zum aktiven Spiegel 43 hin umlenkt. Der vom aktiven Spiegel 43 zurückgeworfene, durch die Randstrahlen 47'' und 48'' repräsentierte, durch den teildurchlässigen Spiegel 51 hindurchtretende Lichtstrom wird mittels einer weiteren telezentrischen Anordnung von Linsen 54 und 56, in deren gemeinsamer Fokalebene der akustooptische Intensitätsmodulator 14 angeordnet ist, auf den für die weitere, bereits erläuterte Ausnutzung des Laser-Lichtstromes geeigneten Querschnitt gebracht, mit dem das durch die Randstrahlen 47' und 48' repräsentierte Laser-Lichtbündel am Ausgang 57 der Strahl-Formungsoptik 49 austritt. Der aktive Spiegel 43, dessen prinzipieller Aufbau in der Fig.4 wiedergegeben ist, ist als sogenannter Folienspiegel ausgebildet. Er umfaßt eine geerdete und verspiegelte Folie 58, die sich zwischen einer transparenten Elektrode 59 und einer Anordnung separat ansteuerbarer Einzelekektroden 61 befindet. Die Gegenelektrode wird auf konstantem Potential $U_0$ gehalten. Durch Anlegen verschiedener Spannungen an die Einzelelektroden ergeben sich auf die Folie 58 wirkende elektrostatische Kräfte, die zu einer gezielten Deformation dieser Folie ausgenutzt werden können, derart, daß der aktive Spiegel eine positive oder negative Brechkraft erhält. Das Ausgangslichtbündel 47', 48' der Strahl-Formungsoptik 49 wird der ersten Abtasteinrichtung 19 zugeleitet, die durch die Rotation des Polygonspiegels 26 die Zeilenablenkung des Laser-Lichtbündels 12 bzw. des Brennflecks 21 in X-Richtung vermittelt. Sie ist zusätzlich auch mit einer Y-Ablenkungseinrichtung 62 versehen, auf deren Ausnutzung im folgenden noch näher eingegangen wird.

Der in der Fig.1 lediglich mit 8 Facetten 63 dargestelllte Polygonspiegel, der um die senkrecht auf der Zeichenebene stehende Achse 64 drehbar ist, hat in einer typischen Realisierungsform 24 Facetten in regelmäßig-polygonaler Anordnung. Er ist mittels eines Elektromotors 66 antreibbar. Die im Rahmen der ersten Abtasteinrichtung 19 zusätzlich vorgesehene Y-Ablenkungseinrichtung 62 ist in für sich bekannter Gestaltung durch einen um eine horizontale Achse 65 schwenkbar antreibbaren Galvanometerspiegel realisiert.

Die Facettenflächen 63 des Polygonspiegels 26 werden in einem telezentrischen Strahlengang, der durch die beiden Linsen 67 und 68 veranschaulicht ist, auf die reflektierende Fläche 69 des Galvanometerspiegels 62 abgebildet. Ein zwischen der Austrittslinse 68 dieses telezentrischen Strahlenganges 67, 68 und dem Galvanometerspiegel 62 angeordneter Umlenkspiegel 71 ist lediglich zur Erzielung einer günstigen Strahlengang-Geometrie vorgesehen.

Mittels einer zu der telezentrischen Linsenanordnung 67, 68 analogen telezentrischen Linsenanordnung 72, 73 wird die reflektierende Fläche 69 des Galvanometerspiegels 72 auf die Eintrittspupille 44 des Mikroskopobjektivs 13 abgebildet, das seinerseits das als Parallelbündel oder nahezu paralleles Lichtbündel durch die Eintrittspupille 44 hindurchtretende Laser-Lichtbündel 12 auf die zu belichtende Fläche der Wafer 11 fokussiert. An der Oberfläche der zu belichtenden Fotolackschicht gestreutes Laserlicht wird in den insoweit erläuterten Strahlengang zurückgeworfen und mittels eines ersten teildurchlässigen Spiegels 74, in der Regel eines halbdurchlässigen Spiegels, der zwischen dem Polygonspiegel 26 und dem Ausgang 57 der Strahl-Formungsoptik 49 angeordnet ist und Bestandteil einer ersten, insgesamt mit 76 bezeichneten Nachweisanordnung ist, in Richtung des Pfeils 77 aus dem Belichtungs-Strahlengang ausgekoppelt. Dieses ausgekoppelte Lichtbündel wird mittels eines weiteren Mikroskopobjektivs 78 fokussiert. In der Brennebene 79 dieses weiteren Mikroskopobjektivs 78 ist eine Lochblende 81 angeordnet, die eine Bündelbegrenzung dahingehend vermittelt, daß durch diese Lochblende 81 nur solches Licht auf einen Fotomultiplier 82 auftreffen kann, das aus dem dem Schärfentiefenbereich des Mikroskopobjektivs 13 entsprechenden Bereich der Fokussierungsebene des Belichtungsstrahlenganges stammt. die erste Nachweisanordnung 76 ist so ausgelegt, daß sie auf UV-Licht der Wellenlänge $\lambda_1$ = 270 nm anspricht, das zur Belichtung der Fotolackschicht ausgenutzt wird.

Mit der ersten Nachweiseinrichtung 76 können - im reflektierten UV-Licht Anschlußmarken "gesehen" werden, die für eine stetige und präzise Anstückelung der Zeilen 27 einander benachbarter streifenförmiger Bereiche 24 vorgesehen sind und jeweils in einem vor der Belichtung der neuen Fotolackschicht durchgeführten Verfahrensschritte erzeugt werden und zwar in schmalen Überlappungsbereichen der einander benachbarten Oberflächenstreifen 24 der Wafer 11. Hierzu sind in dem Rechner 31 die Soll-Orte solcher Erkennungsmarken gespeichert. Tritt das Erkennungssignal des Fotomultipliers 82 im Verlauf eines Belichtungsprozesses früher oder später auf als es der im Rechner 31 gespeicherten Soll-Lage entspricht, so ist dies die Anzeige dafür, daß die Zeilen 27 in dem der Belichtung unterworfenen Streifen 24 der Wafer-Oberfläche gegenüber den Zeilen des zuvor belichteten Streifens versetzt sind. Der Rechner 31 erzeugt hierauf ein Ansteuersignal für die Y-Ablenkungseinrichtung 62 der ersten Abtasteinrichtung, wodurch der Galvanometerspiegel 62 soweit verstellbar ist, daß der Versatz der Zeilen 27 in Y-Richtung wieder kompensiert wird.

Zu demselben Zweck kann auch eine zur ersten Nachweiseinrichtung 76 analoge zweite Nachweis-Einrichtung 83 benutzt werden, die auf die Intensität der nach UV-Bestrahlung in einer Fotolackschicht induzierten Lumineszenz-Strahlung anspricht.

Mittels der zweiten Nachweis-Einrichtung 83 erkennbare Marken können z.B. durch Ausbleichen der Fotolumineszenz in Teilbereichen der Wafer-Oberfläche erzeugt worden sein.

Die zweite Abtast-Einrichtung 38 umfaßt als Abtastelemente einen ersten Galvanometerspiegel 87, der um eine horizontale, d.h. zur Ausbreitungsebene des Abtast-Lichtes parallele Achse 86 schwenkbar ist und die Y-Auslenkung des Abtast-Lichtes vermittelt, sowie einen zweiten Galvanometerspiegel 87, der um eine senkrecht zur Ausbreitungsebene des Abtast-Lichtes verlaufende Achse 88 schwenkbar ist und demgemäß die X-Zeilenauslenkung vermittelt. Als Abtastlicht wird im Rahmen der zweiten Abtast-Einrichtung 38 der vom Ausgangslichtstrom 46, 47, 48 des Argonlasers abgezweigte Teillichtstrom 41 der Wellenlänge $\lambda_2$ = 514 nm ausgenutzt. Dieser Teillichtstrom 41 wird in der aus der Fig. 1 ersichtlichen Geometrie über einen ersten, für das UV-Laserlicht durchlässigen, für die Wellenlänge 514 nm reflektierenden Spiegel 89, einen Umlenkspiegel 91, einen teildurchlässigen Spiegel 92, die zweite Abtast-Einrichtung 38 und einen weiteren teildurchlässigen Spiegel 93 in den für die Beleuchtung der Wafer-Oberfläche vorgesehenen Strahlengang eingekoppelt. wobei diese Einkopplung des weiteren Abtast-Lichtstromes 41 zwischen dem Galvanometerspiegel 62 der ersten Abtast-Einrichtung 19 und der einen Linse 72 der telezentrischen Linsenanordnung 72, 73 erfolgt, die vor der Eintrittspupille 44 des Mikroskopobjektivs 17 angeordnet ist.

Zwischen einer Abbildungslinse 94, die das von der Wafer-Oberfläche reflektierte Abtastlicht, das zur Ermittelung der Punktbildfunktion ausgenutzt wird, auf die Diodenmatrix 39 fokussiert und dem teildurchlässigen Spiegel 92, der den Abtastlichtstrom 41 in die zweite Abtast-Einrichtung 38 einkoppelt, sind zu der ersten und der zweiten Nachweis-Einrichtung 76 bzw. 83 analoge, weitere Nachweis-Einrichtungen 76' und 83'vorgesehen, die ebenfalls die Erkennung von Anschlußmarken ermöglichen, deren Lage in Relation zu den im Rechner 31 gespeicherten Soll-Orten nunmehr anhand des reflektierten Abtastlichtes (Nachweisanordnung 76') bzw. wiederum der erfaßten Lumineszenzstrahlung (Nachweiseinrichtung 83') erkannt wird, wie schon anhand der Nachweis-Einrichtung 83 erläutert.

Mit dem anhand der Fig.1 erläuterten Laserstrahl-Lithographen 10 ist eine Belichtungsfrequenz von 40 MHz erreichbar, d.h. es können pro Sekunde 40 Millionen Bildelemente(Pixel) einer Belichtungsstruktur erzeugt werden.

In bevorzugter Gestaltung des erfindungsgemäßen Laserstrahl-Lithographen ist anstelle der Strahlformungsoptik 49 gemäß Fig.1 eine ihrem grundsätzlichen Aufbau nach in der Fig.5 wiedergegebene Strahlformungs- und Nachfokussierungsoptik 49' vorgesehen, die zwei im vorstehend erläuterten Sinne aktive Spiegel 43' und 43" umfaßt, welche in dem aus der Fig.5 ersichtlichen Z-Strahlengang zwischen den zu den telezentrischen Linsensystemen 52, 53 und 54, 56 analogen Linsensystem 52', 53' bzw. 54', 56' angeordnet sind. Die beiden aktiven Spiegel 43' und 43" sind als Facettenspiegel ausgebildet, die jeweils dieselbe Anzahl von sphärischen Facettenflächen 96 bzw. 97 haben. Je eine der sphärischen Facetten 96 des einen aktiven Spiegels 43' ist mit einer der sphärischen Facetten 97 des anderen aktiven Spiegels 43' so konjugiert, daß sie einen gemeinsamen Fokus haben, wobei die zentralen Achsen 98 der über jeweils eines der Facettenpaare 96, 97 Z-förmig reflektierten, konvergenten Lichtbündel im wesentlichen parallel zueinander verlaufen.

Mittels einer insgesamt mit 99 bezeichneten Anordnung akusto-optischer Modulatoren, die in der gemeinsamen Brennebene der Spiegelfacetten 96 und 97 angeordnet sind, sind die Intensitäten der zwischen den beiden aktiven Spiegeln 43' und 43" konvergenten Lichtbündel rechnergesteuert einzeln modulierbar. Die Brechkräfte und Orientierungen der Spiegelfacetten 96 und 97 sind durch Rechner-gesteuerte Spannungsbeaufschlagung der Steuerelektroden der aktiven Spiegel 43' und 43" so eingestellt, daß sich in der funktionellen Kombination der Strahl-Formungsoptik 49' mit den weiteren Funktionselementen des Laserstrahl-Lithographen, wie im übrigen in der Fig.1 dargestellt, auf der Oberfläche der Wafer 11 eine sich in Y-Richtung erstreckende lineare oder nahezu lineare Anordnung dicht nebeneinander liegender Brennflecke ergibt, deren Abstand z.B. dem halben Brennfleck-Durchmesser entspricht. Mithilfe der Strahlformungs-Optik 49' ist dann in der zur vorstehend erläuterten analogen Weise ein Mehrkanalbetrieb des Laser-Lithographen 10 möglich, mit der Folge, daß die Arbeitsfrequenz um den der Zahl der Belichtungskanäle entsprechenden Faktor erhöht wird.

## Ansprüche

1. Laserstrahl-Lithograph für die Herstellung von hochintegrierten Halbleiter-Bauelementen, deren Funktionselemente durch Aufbringen detailreich strukturierter Schichten unterschiedlicher elektrischer Leitungseigenschaften auf einen Wafer geschaffen werden, wobei die Aufzeichnung der in einer Schicht vorgesehenen Linien- und Flächenstruktur durch strukturkonforme Belichtung einer auf die für die jeweilige Phase des Produktionsvorganges charakteristische Oberfläche aufgebrachten Fotolackschicht erfolgt, mit mindestens einem Belichtungskanal, mit dem die der Belichtung zu unterwerfende Fläche der Fotolackschicht überstreichbar ist, wobei die hierfür erforderlichen Relativbewegungen der Wafer und des Belichtungsstrahls sowohl durch Auslenkung desselben als auch durch rechnergesteuerte Bewegungen der Wafer in zwei zueinander orthogonalen Koordinatenrichtungen erfolgt, sowie mit einem akusto-optischen Modulator (14) zur Intensitätsmodulation des Belichtungsstrahls, dadurch gekennzeichnet, daß der Beleuchtungs-Strahlengang als Fokussierungselement mindestens einen aktiven Spiegel ( 43; 43', 43" ) mit elektrisch steuerbarer Brennweite umfaßt, daß eine Abtast-Einrichtung ( 38 ) vorgesehen ist, mit der die räumliche Verteilung eines an gezielt auswählbaren Flächenelementen der Wafer ( 11 ) reflektierten Testlichtes ( 41 ) erfaßbar ist, und daß im Rahmen des zur Belichtungssteuerung und zur Erfassung der Intensitätsverteilung des reflektierten Lichtes (Punktbildfunktion) vorgesehenen Rechners eine Vergleichseinrichtung vorgesehen ist, die aus dem Vergleich der erfaßten Punktbildfunktion mit einer für optimale Fokussierung des Test-Lichtes bzw. des Belichtungs-Lichtstromes charakteristischen idealen Punktbildfunktion Ansteuersignale für den aktiven Spiegel ( 43; 43', 43" ) im Sinne der Einstellung einer definierten Fokussierungsbedingung erzeugt.

2. Laserstrahl-Lithograph nach Anspruch 1, dadurch gekennzeichnet, daß eine Strahl-Aufteilungseinrichtung ( 43', 43" ) vorgesehen ist, die eine Aufteilung des Primärstrahles eines zur Belichtung vorgesehenen Lasers ( 37 ) in eine Anzahl von Teilstrahlen vermittelt, deren Intensitäten mittels einer Modulator-Anordnung ( 99 ) unabhängig voneinander veränderbar sind, wobei die aus der Aufteilung des Primärstahls resultierenden Teillichtbündel einzeln auf die zu belichtende Wafer-Fläche fokussierbar sind.

3. Laserstrahl-Lithograph nach Anspruch 1 oder Anspruch 2, dadurch gekennzeichnet, daß eine Strahl-Formungsoptik (49') vorgesehen ist, die eine Aufteilung des Primärstrahles der zur Belichtung der Fotolackschicht vorgesehenen Wafer-Lichtquelle ( 37 ) in eine Mehrzahl von Teilstrahlen vermittelt, die einzeln auf die zu belichtende Fläche fokussierbar sind, und deren Intensitäten mit je einem akusto-optischen Modulator separat steuerbar sind.

4. Laserstrahl-Lithograph nach Anspruch 3, dadurch gekennzeichnet, daß eine zur Aufteilung des Primär-Strahles der Laserlichtquelle ( 37 ) vorgesehene Strahl-Formungsoptik ( 49' )zwei aktive Spiegel ( 43' und 43" ) umfaßt, die jeweils dieselbe Anzahl von sphärischen Facettenflächen ( 96 und 97 ) in konfokaler Anordnung umfaßen, und daß eine Modulator-Anordnung, die eine der Anzahl der konjugierten Facettenpaare ( 96, 97 ) entsprechende Anzahl von akusto-optischen Modulatoren umfaßt, in der gemeinsamen Fokalebene der beiden aktiven Spiegel ( 43' und 43" ) angeordnet ist.

5. Laserstrahl-Lithograph nach einem der vorhergehenden Ansprüche,
dadurch gekennzeichnet, daß mindestens eine fotoelektrische Nachweis-Anordnung ( 76; 83;76' ;83' ) vorgesehen ist, mit der die Intensität in den Belichtungs-Strahlengang oder in den Abtast-Strahlengang zurückgeworfenen Lichtes erfaßbar ist, das von ausgewählten Punkten der Wafer-Oberfläche reflektiert oder durch Lumineszenz emittiert worden ist.

## Claims

1. Laser lithograph for the manufacture of large-scale integrated semi-conductor components, the functional elements of which are produced by the introduction of layers which are of different electrical conductor properties and structured to be rich in detail, onto a wavers, in which respect the drawing of the line- and surface structure, intended to be in one layer, is carried out by structurally concurring light exposure of a photo-enamel layer which is applied to a surface which is characterisic of the respective phase of the production process, by means of at least one light-exposure channel by which the photo-enamel-layer surface to be subjected to the light exposure is covered, whereby therefor required relative movements of the wafer and of the exposure beam are carried out both by sweeping and by computer-controlled movements of the wafer in two co-ordinate directions which are orthogonal relative to one another, and with an acousto-optical modulator (14) for intensity modulation of the exposure beam, **characterised in that** the light-beam path as a focussing element comprises at least one active mirror (43; 43', 43") with electrically controlled focal length, in that a scanning device (38) is provided, by which the spread of a test light (41), which is reflected on selectively chosen surface elements of the wafer (11), is detected, and in that in the framework of the computer, which is provided for the exposure control and for the detection of the intensity spread of the reflected light (point-image function), a comparator device is provided which produces control signal for the active mirror (43; 43', 43") relative to setting a defined focussing condition, resulting from the comparison of the detected point-image function with an ideal point-image function characteristic for optimum focussing of the test-beam or the exposure-light-current.

2. Laser lithograph according to claim 1, **characterised in that** a beam-dividing device (43', 43") is provided which conveys a division of the primary beam of an exposure laser (37) into a number of sectional beams, the intensities of which are adjustable independent from each other by means of a modulator arrangement (99), whereby the sectional light beams, which result from the division of the primary beam, can be focussed individually onto the wafer surface to be exposed.

3. Laser lithograph according to claim 1 or claim 2, **characterised in that** a beam-forming optics (49') is provided which conveys a division of the primary beam of the wafer light source (37), which is required for the light exposure of the photo-enamel layer, into a plurality of sectional beams which can be focussed individually onto the surface to be exposed and the intensities of which can be separately controlled by means of each one acousto-optical modulator.

4. Laser lithograph according to claim 3, **characterised in that** a beam-forming optics (49'), which is provided for the division of the primary beam of the laser light source (37), comprises two active mirrors (43' and 43"), which each comprise the same number of spherical facet surfaces (96 and 97) in co-focal arrangement, and in that a modulator arrangement, comprising a number of acousto-optical modulators corresponding to the number of conjugated facet pairs (96, 97), is arranged in the common focal plane of the two active mirrors (43' and 43").

5. Laser lithograph according to one of the above claims, **characterised in that** at least one photo-electric detection arrangement (76; 83; 76'; 83') is provided, by which the intensity of light, which has been reflected from selected points of the wafer surface or emitted by the luminescence, is detected in the exposure-beam path or in the scanning-beam path.

## Revendications

1. Presse lithographique à rayon laser pour la fabrication de composants semiconducteurs hautement intégrés dont les éléments fonctionnels sont produits en recouvrant une "galette", ou lame, de couches structurées riches en détails aux propriétés de conductibilité électrique variées, l'enregistrement de la structure de lignes et de surfaces prévue dans une couche s'effectuant par exposition, conforme à cette structure, d'une couche de laque photosensible appliquée sur la surface caractéristique chaque fois de la phase concernée du processus de fabrication, la presse étant équipée d'au moins un canal d'exposition au moyen duquel la surface de la couche de laque photosensible à exposer peut être balayée, les mouvements relatifs de la lame et du rayon éclairant nécessaires à ce balayage s'effectuant tant par déviation de ce rayon que par des déplacements de la lame, commandés par calculateur, dans deux directions de coordonnées orthogonales l'une à l'autre, ainsi que d'un modulateur acoustico-optique (14) pour la modulation en intensité du rayon éclairant, caractérisée en ce que le parcours du rayon éclairant comprend, en tant qu'organe de focalisation, au moins un miroir actif (43 ; 43', 43") à distance focale réglable par voie électrique, en ce qu'il est prévu un équipement explorateur (38) au moyen duquel la répartition dans l'espace d'une lumière d'essai (41) réfléchie sur des éléments de surface judicieusement choisis de la lame (11) peut être décelée, et en ce que dans le cadre du calculateur prévu pour la commande de l'exposition et pour la détection de la répartition de l'intensité de la lumière réfléchie (fonction d'image ponctuelle) il est prévu un comparateur qui à partir de la comparaison de la fonction d'image ponctuelle décelée avec une fonction d'image ponctuelle idéale caractéristique d'une focalisation optimale de la lumière d'essai, c'est-à-dire du flux lumineux éclairant, génère des signaux de commande pour le miroir actif (43, 43', 43") en vue du réglage de conditions de focalisation bien définies.

2. Presse lithographique à rayon laser selon la revendication 1, caractérisée en ce qu'il est prévu un équipement de décomposition de rayon (43', 43") qui réalise une décomposition du rayon primaire d'un laser (37), prévu à des fins d'exposition, en un certain nombre de rayons partiels dont les intensités peuvent être variées indépendamment les unes des autres au moyen d'un dispositif modulateur (99), les faisceaux lumineux partiels résultant de la décomposition du rayon primaire pouvant être focalisés individuellement sur la surface à exposer de la lame.

3. Presse lithographique à rayon laser selon la revendication 1 ou 2, caractérisée en ce qu'il est prévu une optique de formation de rayon qui réalise une décomposition du rayon primaire de la source lumineuse laser (37), prévue pour l'exposition de la couche de laque photosensible, en un certain nombre de rayons partiels qui peuvent être focalisés individuellement sur la surface à exposer, et dont les intensités peuvent chacune être réglées séparément par un modulateur acoustico-optique.

4. Presse lithographique à rayon laser selon la revendication 3, caractérisée en ce qu'une optique de formation de rayon (49') prévue pour la décomposition du rayon primaire de la source lumineuse laser (37) comprend deux miroirs actifs (43' et 43") qui comprennent chacun le même nombre de surfaces formant facettes sphériques (96 et 97) dans une disposition à foyer commun, et en ce qu'un dispositif modulateur, qui comprend un nombre de modulateurs acoustico-optiques correspondant au nombre des paires de facettes conjuguées (96, 97), est disposé dans le plan focal commun des deux miroirs actifs (43' et 43").

5. Presse lithographique à rayon laser selon l'une quelconque des revendications précédentes, caractérisée en ce qu'il est prévu au moins un dispositif indicateur photoélectrique (76 ; 83 ; 76' ; 83') au moyen duquel peut être décelée l'intensité de la lumière qui, renvoyée dans le parcours du rayon éclairant ou dans le parcours de rayons explorateurs, a été réfléchie par des points sélectionnés de la surface de la lame ou a été émise par luminescence.

Fig.1

EP 0 173 849 B1

10

Fig. 2

Fig. 4

EP 0 173 849 B1

Start $\quad \exp iK\varphi_0(x,Y)$

gemessene Intensität

$I_m(u,v)$

$\mathscr{F}$

$\exp iK\varphi_{1\cdots n}(x,Y)$

$\sqrt{I(u,v)} \cdot \exp i\gamma(u,v)$

$$R'(x,Y) = \begin{cases} 1, & x^2 + Y^2 \leqslant 1 \\ 0, & x^2 + Y^2 > 1 \end{cases} \quad \text{wenn:}$$

ersetze $I$ durch $I_m$

$I \longrightarrow I_m$

$\mathscr{F}^{-1}$

$R'(x,Y) \cdot \exp iK\varphi_{1\cdots n}(x,Y)$

$\sqrt{I_m(u,v)} \cdot \exp i\gamma(u,v)$

Pupillenebene

Brenn - (Fourier -) ebene

Fig. 3

Fig. 5